# EUROPÄISCHE PATENTSCHRIFT

(11) **EP 3 451 536 B1**
(45) Veröffentlichungstag und Bekanntmachung des Hinweises auf die Patenterteilung: **06.05.2026**
(21) Anmeldenummer: 18191885.5
(22) Anmeldetag: 31.08.2018
(51) Int. Cl.: H03K 17/96, H03K 17/955

(54) **KAPAZITIVE SENSORANORDNUNG UND FAHRZEUGAUSSENGRIFF**
CAPACITATIVE SENSOR ASSEMBLY AND EXTERNAL VEHICLE HANDLE
DISPOSITIF CAPTEUR CAPACITIF ET POIGNÉE EXTÉRIEURE DE VÉHICULE

(30) Priorität: 01.09.2017 DE 102017215333
(43) Veröffentlichungstag der Anmeldung: 06.03.2019
(73) Patentinhaber: Witte Automotive GmbH, 42551 Velbert (DE)
(72) Erfinder: Lesák, Vit, 18100 Praha 8-Bohnice (CZ); Skála, Pavel, 36221 Nejdek (CZ); Ducka, Radek, 43111 Jirkov (CZ)
(74) Vertreter: Liedtke & Partner Patentanwälte

(56) Entgegenhaltungen:
- EP-B1- 1 450 489
- WO-A1-2014/032988
- DE-A1- 102007 048 402
- DE-A1- 102007 051 495
- DE-A1- 102011 010 919
- DE-U1- 202006 010 813
- JP-A- 2012 129 762
- US-A1- 2014 015 595
- US-A1- 2016 277 023
- US-A1- 2017 214 400

## Beschreibung

Die Erfindung betrifft eine kapazitive Sensoranordnung zum Erfassen mindestens eines sich nähernden Objektes, eine Fahrzeugaußenoberfläche und einen Fahrzeugaußengriff mit einer solchen kapazitiven Sensoranordnung.

Kapazitive Sensoranordnungen sind allgemein bekannt als Annäherungs- oder Berührungssensoren zur kapazitiven Berührungserkennung, um beispielsweise an einem Griff, wie einen Fahrzeugaußengriff, eine sich annähernde Hand oder eine Handpräsenz/-bedienung zu erkennen und eine Funktion, wie eine Verriegelungs- oder Entriegelungsfunktion freizugeben oder zu sperren.

Zum Beispiel sind kapazitive Sensoranordnungen aus der DE 10 2011 010 919 A1, WO 2014/032988 A1, DE 10 2007 048402 A1 und JP 2012 129762 A bekannt. Aus der EP 1 450 489 B1 ist ein Auslösesignalgeber, beispielsweise zur Einleitung eines Frage-/Antwort-Dialogs im Rahmen einer Zugangsberechtigungsprüfung bei einem Kraftfahrzeug, zur Betätigung eines Kraftfahrzeugtürverschlusses bekannt.

Nachteilig insbesondere bei einem Fahrzeugaußengriff sind aufgrund beispielsweise von starkem Regen Fehlerkennungen, wodurch es zu unerwünschten Auslösung einer Verriegelungs- oder Entriegelungsfunktion kommen kann.

Der Erfindung liegt die Aufgabe zu Grunde, eine kapazitive Sensoranordnung zum Erfassen mindestens eines sich nähernden Objektes anzugeben, mit welcher Fehlerkennungen und/oder Fehlauslösungen weitgehend vermieden sind. Des Weiteren ist eine Fahrzeugaußenoberfläche und ein Fahrzeugaußengriff mit einer verbesserten kapazitiven Sensoranordnung anzugeben.

Die Aufgabe wird erfindungsgemäß gelöst durch eine kapazitive Sensoranordnung mit den Merkmalen des Patentanspruchs 1. Hinsichtlich der Fahrzeugaußenoberfläche oder des Fahrzeugaußengriffs wird die Aufgabe erfindungsgemäß durch die Merkmale des Patentanspruchs 13 bzw. 14 gelöst.

Vorteilhafte Ausgestaltungen der Erfindung sind Gegenstand der Unteransprüche.

Die erfindungsgemäße kapazitive Sensoranordnung zum Erfassen mindestens eines sich nähernden Objektes ist als ein Berührungssensor ausgebildet und umfasst eine Mehrzahl von Elektroden, die jeweils als Flächenelektroden ausgebildet und zueinander ausgerichtet und voneinander beabstandet angeordnet sind, wobei jede Elektrode eine vorgegebene Kapazität aufweist und mit einer Auswerteeinheit verbunden ist, welche Änderungen in der Kapazität der jeweiligen Elektrode erfasst, wobei eine der Elektroden als eine Hauptelektrode ausgebildet ist und die anderen Elektroden als Hilfselektroden ausgebildet sind, wobei die Auswerteeinheit eingerichtet ist, alle Elektroden gemeinsam zu überwachen derart, dass Änderungen der Kapazitäten der mehreren Hilfselektroden und Änderungen der Kapazität der Hauptelektrode erfasst und miteinander verglichen werden. Darüber hinaus ist die Auswerteeinheit eingerichtet, die erfassten Änderungen der Kapazität der Hauptelektrode anhand der erfassten Änderungen der Kapazitäten der mehreren Hilfselektroden auf Plausibilität und/oder Konsistenz zu prüfen, ob eine Berührung der Hauptelektrode oder eine Annäherung an die Hauptelektrode erfolgt ist oder nicht.

Durch die Überprüfung der erfassten Kapazitätsänderungen der Hauptelektrode im Vergleich mit den erfassten Kapazitätsänderungen der mehreren Hilfselektroden anhand einer Plausibilitätskontrolle können Bedienungsberührungen sicher und eindeutig identifiziert werden. Insbesondere können Fehlauslösungen/ -berührungen, beispielsweise verursacht durch Schmutzwasser, Regen, Spritzwasser oder ähnlichem, herausgefiltert werden. Somit sind Falschbedienungen oder Falschauslösungen vermieden. Dazu wird beispielsweise die jeweilige Schaltfunktion bei Identifizierung einer Fehlauslösung durch die Plausibilitätskontrolle gesperrt.

Die kapazitive Sensoranordnung ist insbesondere als ein Berührungssensor ausgebildet, welcher bei Berührung durch ein Objekt oder bei einer Annäherung eines Objekts an diesen seine Kapazität ändert.

Die mit der Erfindung erzielten Vorteile bestehen insbesondere darin, dass aufgrund des Vorsehens von Hilfselektroden zusätzlich zur Haupt- oder Messelektrode das erfasste Mess- oder Sensorsignal, insbesondere die erfasste Änderung der Kapazität der Hauptelektrode auf Plausibilität durch die erfassten Mess- oder Sensorsignale, insbesondere durch deren erfasste Änderungen der Kapazitäten der Hilfselektroden geprüft werden kann. Hierdurch ist eine sichere Auslösung oder ein sicheres Sperren einer Schaltfunktion, wie einer Ent- oder Verriegelungsfunktion, bei einer identifizierten Berührung oder Annäherung eines Objektes an die Hauptelektrode ermöglicht. Insbesondere wird mittels der Hilfselektroden die Umgebung der Hauptelektrode überwacht. Bei einer sicheren Erkennung einer Berührung der Hauptelektrode wird dann beispielsweise mittels der Auswerteeinheit ein Steuersignal ausgelöst, dass eine entsprechende Funktion, wie eine Schließ-, Öffnen-, Entriegelungs- oder Verriegelungsfunktion, steuert, beispielsweise auslöst oder sperrt.

Beispielsweise ist die Auswerteeinheit eingerichtet, bei ermittelter fehlender Plausibilität eine Auslösung einer Funktion, wie zum Beispiel einer Schaltfunktion, zu sperren oder bei ermittelter gegebener Plausibilität eine Auslösung der Funktion, wie zum Beispiel der Schaltfunktion, freizugeben.

Eine Weiterbildung sieht beispielsweise vor, dass die Auswerteeinheit eingerichtet ist, in Abhängigkeit von den ermittelten Änderungen der Kapazität der Hauptelektrode und/oder Hilfselektroden ein Schaltsignal auszulösen oder eine solche Auslösung eines Schaltsignals zu sperren.

In einer möglichen Ausführungsform sind die Elektroden als Streifenelektroden und/oder Rechteckelektroden ausgebildet. Beispielsweise weist die Hauptelektrode größere Abmessungen als die Hilfselektroden auf. Insbesondere weist die Hauptelektrode eine an das sich annähernde Objekt angepasste Größe, Form und/oder Abmessungen auf. Soll beispielsweise mittels der Hauptelektrode eine Annäherung und/oder Berührung einer Hand oder eines Fingers erfasst werden, so kann die Hauptelektrode beispielsweise eine kissenähnliche Form für die Hand bzw. streifenähnliche Form für den Finger aufweisen. Dabei dient die Hauptelektrode als Messelektrode, welche zur Auslösung einer Funktion zu betätigen oder zu berühren ist.

Bei einer beispielsweise außen an einem Fahrzeug angeordneten kapazitiven Sensoranordnung ermöglicht die Auswerteeinheit das Aktivieren unterschiedlicher Funktionen des Fahrzeugs, wie beispielsweise Öffnen oder Schließen einer Fahrzeugtür, Entriegeln oder Verriegeln eines Heck- oder Frontklappenschlosses, Öffnen oder Schließen einer Heck- oder Frontklappe.

Die Hilfselektroden dienen insbesondere der Überwachung der Umgebung der Haupt- oder Messelektrode. Beispielsweise werden mittels der Hilfselektroden Fehlsignale, die beispielsweise durch mechanische Beanspruchung, wie Staub, Regen oder Schmutz, verursacht sind, erkannt und eine Fehlauslösung unterdrückt, indem eine Auslösung der Funktion gesperrt oder unterdrückt wird.

Eine weitere Ausführungsform sieht vor, dass die Hilfselektroden als Streifenelektroden ausgebildet sind und jeweils benachbart zur Hauptelektrode angeordnet sind. Beispielsweise weisen die jeweilige Hilfs- oder Streifenelektroden eine Länge auf, die einer Seitenlänge der Hauptelektrode entspricht. In einer möglichen Ausführungsform sind zumindest zwei der Hilfs- oder Streifenelektroden vertikal ausgerichtet und seitlich der Hauptelektrode parallel zu deren Seiten angeordnet. Zusätzlich kann zumindest eine der Hilfselektroden horizontal ausgerichtet sein und oberhalb und/oder unterhalb der Hauptelektrode parallel zu dieser angeordnet sein. Eine solche teilweise oder vollständig um die Hauptelektrode herum vorgesehene Anordnung von Hilfselektroden ermöglicht eine entsprechende teilweise bzw. vollständige Überwachung und Erfassung der Umgebung der Hauptelektrode. Hierdurch kann das Messsignal der Hauptelektrode sicher anhand der Messsignale aus der Umgebung überprüft und auf Plausibilität ausgewertet werden.

Beispielsweise gibt bei einer erfassten Änderung der Kapazität in der Hauptelektrode über einen vorgegebenen Referenzwert hinaus die Auswerteeinheit ein Schaltsignal für eine Funktion, beispielsweise eine Verriegelungs- oder Entriegelungsfunktion, aus. Dabei kann bei einer erfassten Änderung der Kapazität nur in den zu der Hauptelektrode benachbarten Elektroden die Auswerteeinheit die Auslösung eines Schaltsignals sperren. Alternativ kann bei einer Erfassung von Änderungen der Kapazität in allen Elektroden erst dann eine Funktion ausgelöst werden, wenn zumindest der Referenzwert für die Kapazität der Hauptelektrode überschritten ist.

Darüber hinaus ist die Auswerteeinheit eingerichtet, einen zeitlichen Versatz und/oder eine Reihenfolge der Änderungen der Kapazitäten der Haupt- und/oder Hilfselektroden zu ermitteln und auszuwerten. Durch eine solche spezifische Auswertung der erfassten Änderungen der Kapazitäten können Freigabebedingungen für die Funktion zusätzlich definiert werden. Auch kann dadurch auf vorliegende Bedingungen in der Umgebung der Hauptelektrode oder an der Hauptelektrode selbst geschlossen werden, wie beispielsweise auf eine starke Verschmutzung des Sensors, wobei die Auswerteeinheit ein entsprechendes Wartungssignal oder Reinigungssignal auslösen kann.

Insbesondere ist die Auswerteeinheit eingerichtet, den ermittelten zeitlichen Versatz und/oder die ermittelte Reihenfolge der Änderungen der Kapazitäten der Hauptelektrode und/oder der Änderungen der Kapazitäten der Hilfselektroden auf Plausibilität dahingehend zu prüfen, ob eine Berührung der Hauptelektrode oder eine Annäherung an die Hauptelektrode erfolgt ist oder nicht.

Die kapazitive Sensoranordnung findet insbesondere Anwendung an einer Außenseite, beispielsweise an einer Fahrzeugaußenoberfläche, zum Beispiel an einer A-Säule oder an einem Griff eines Fahrzeugs. Zum Beispiel ist ein Fahrzeugaußengriff, welcher insbesondere starker Verschmutzung, Regen, oder sonstigen Beanspruchungen, ausgesetzt ist, mit einer solchen kapazitiven Sensoranordnung versehen.

Ausführungsbeispiele der Erfindung werden im Folgenden anhand von Zeichnungen näher erläutert.

Darin zeigen:
- Figur 1A: schematisch ein Fahrzeug mit einer außenseitig angeordneten kapazitiven Sensoranordnung,
- Figur 1B: schematisch in vergrößerter Darstellung eine Fahrzeugtür mit einem Fahrzeugaußengriff, der eine kapazitive Sensoranordnung als Berührungssensor umfasst,
- Figur 2: schematisch eine mögliche Ausführungsform einer kapazitiven Sensoranordnung in einem ersten Betriebszustand,
- Figur 3: schematisch die kapazitive Sensoranordnung in einem zweiten Betriebszustand,
- Figur 4: schematisch die kapazitive Sensoranordnung in einem dritten Betriebszustand, und
- Figur 5: schematisch in vergrößerter Darstellung eine Kopplung der kapazitiven Sensoranordnung mit einer Auswerteeinheit und einer Schalteinheit.

Einander entsprechende Teile sind in allen Figuren mit den gleichen Bezugszeichen versehen.

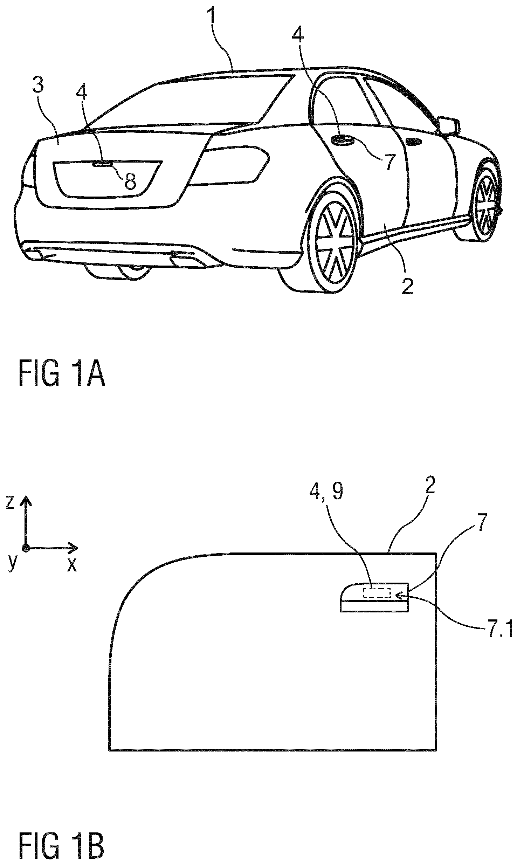

**Figur 1A** zeigt schematisch ein Fahrzeug 1. Das Fahrzeug 1 weist auf seiner Außenseite mehrere elektronisch schaltbare Bereiche auf. Beispielsweise weist das Fahrzeug 1 im Bereich einer Tür 2 oder einer Heckklappe 3 eine kapazitive Sensoranordnung 4 zum Erfassen mindestens eines sich annähernden oder diesen berührenden Objektes 5, wie die Hand eines Nutzers, auf.

Die kapazitive Sensoranordnung 4 ermöglicht in einfacher Art und Weise das Aktivieren einer entsprechenden Funktion des Fahrzeugs 1, wie beispielsweise Öffnen oder Schließen der Tür 2, Schließen und/oder Öffnen einer Motorhaube, eines Schiebedachs, eines Hubdachs, eines Fahrzeugfensters und/oder eines Tankdeckels, Entriegeln oder Verriegeln eines Heck- oder Frontklappenschlosses, Öffnen oder Schließen der Heckklappe 3. Hierzu kann das Fahrzeug 1 mit mehreren kapazitiven Sensoranordnungen 4 ausgestattet sein.

Die kapazitive Sensoranordnung 4 kann beispielsweise Teil eines Fahrzeugaußengriffs 7 oder eines Heckklappengriffs 8 sein.

Die Erfindung wird nachfolgend beispielhaft anhand des Fahrzeugaußengriffs 7 näher beschrieben. Die kapazitive Sensoranordnung 4 des Heckklappengriffs 8 weist eine gleiche Funktion und einen gleichen Aufbau auf.

**Figur 1B** zeigt schematisch in vergrößerter Darstellung die Fahrzeugtür 2 mit dem Fahrzeugaußengriff 7, der die kapazitive Sensoranordnung 4 umfasst, die als Berührungssensor 9 ausgebildet ist. Der Berührungssensor 9 ist dabei integraler Teil des Fahrzeugaußengriffs 7. Beispielsweise ist der Berührungssensor 9 in einer Griffblende 7.1 des Fahrzeugaußengriffs 7 integriert, beispielsweise in eine äußere Zierschicht, insbesondere Lackschicht eingespritzt.

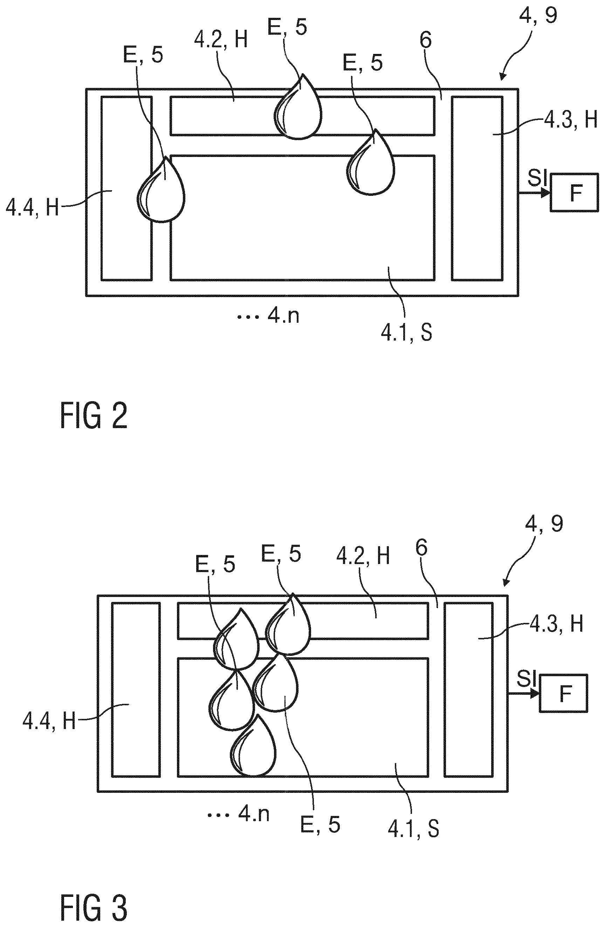

**Figur 2** zeigt schematisch ein Ausführungsbeispiel der kapazitiven Sensoranordnung 4 zum Erfassen des Objektes 5.

Dabei umfasst die kapazitive Sensoranordnung 4 eine Mehrzahl von Elektroden 4.1 bis 4.n, die jeweils als Flächenelektroden ausgebildet und zueinander ausgerichtet und voneinander beabstandet angeordnet sind.

Jede Elektrode 4.1 bis 4.n weist eine vorgegebene Kapazität auf. Je nach Art und Auslegung der Elektroden 4.1 bis 4.n ist die kapazitive Sensoranordnung 4 als ein Berührungssensor ausgebildet, der auf Annäherung und/oder Berührung des Sensors durch das Objekt 5 reagiert, insbesondere seine Kapazität ändert. Beispielsweise wird dabei die sich ändernde elektrische Kapazität der Elektrode 4.1 bis 4.n im Vergleich zur Umgebung oder einer Referenzelektrode bestimmt. Beispielsweise ist jede Elektrode 4.1 bis 4.n als ein Oszillator, insbesondere ein RC-Schwingkreis ausgebildet, der bei Annährung des Objektes 5 die Schwingfrequenz ändert, infolge dessen sich die Kapazität ändert, die erfasst wird.

Jede Elektrode 4.1 bis 4.n ist mit einer Auswerteeinheit 6 verbunden. Die Auswerteeinheit 6 ist beispielsweise eine integrierte Schaltung oder ein Mikroprozessor. Die Auswerteeinheit 6 erfasst beispielsweise als Messsignal die Änderungen in der Kapazität oder Schwingfrequenz der jeweiligen Elektrode 4.1 bis 4.n.

In einer einfachen Ausführungsform ist eine der Elektroden 4.1 als Hauptelektrode S (auch Sensor- oder Messelektrode genannt) ausgebildet. Die anderen Elektroden 4.2 bis 4.n sind als Hilfselektroden H oder Referenzelektroden ausgebildet.

Die Auswerteeinheit 6 ist eingerichtet, alle Elektroden 4.1 bis 4.n gemeinsam zu überwachen. Hierzu sind die Elektroden 4.1 bis 4.n in herkömmlicher Art und Weise mit der Auswerteeinheit 6 gekoppelt.

Die Auswerteeinheit 6 ist derart eingerichtet, dass Änderungen der Kapazitäten der mehreren Hilfselektroden H und Änderungen der Kapazität der Hauptelektrode S erfasst und miteinander verglichen werden.

Für eine sichere Auslösung oder ein sicheres Sperren einer Schaltfunktion, wie einer Ent- oder Verriegelungsfunktion, bei einer identifizierten Berührung oder Annäherung des Objektes 5 an die Hauptelektrode S wird mittels der Hilfselektroden H die Umgebung der Hauptelektrode S überwacht.

Bei einer sicheren Erkennung einer Berührung der Hauptelektrode S wird dann beispielsweise mittels der Auswerteeinheit 6 ein Steuersignal SI ausgelöst, dass eine entsprechende Funktion F, wie eine Schließ-, Öffnen-, Entriegelungs- oder Verriegelungsfunktion, steuert, beispielsweise auslöst oder sperrt.

Hierbei ist die Auswerteeinheit 6 eingerichtet, in Abhängigkeit von den ermittelten Änderungen der Kapazität der Hauptelektrode S und/oder Hilfselektroden H ein Schalt- oder Steuersignal SI auszulösen oder eine solche Auslösung eines Schalt-/Steuersignals SI zu sperren.

**Figuren 2 bis** 4 zeigen beispielhaft als Elektroden 4.1 bis 4.n Streifenelektroden und/oder Rechteckelektroden. Beispielsweise weist die Hauptelektrode S größere Abmessungen als die Hilfselektroden H auf. Insbesondere weist die Hauptelektrode S eine an das sich annähernde Objekt 5 angepasste Größe, Form und/oder Abmessungen auf.

Die Hilfselektroden H sind im Ausführungsbeispiel als Streifenelektroden ausgebildet. Die Hilfselektroden H können aber auch eine andere geeignete Form aufweisen.

Die Hilfselektroden H sind jeweils benachbart zur Hauptelektrode S angeordnet. Beispielsweise weisen die jeweilige Hilfselektroden H eine Länge auf, die einer Seitenlänge der Hauptelektrode S entspricht.

Zudem sind die Hilfselektroden H verteilt um die Hauptelektrode S und in einem Abstand zu dieser angeordnet.

In dem gezeigten Ausführungsbeispiel sind zwei der Hilfselektroden H (Elektroden 4.3 und 4.4) vertikal ausgerichtet und seitlich der Hauptelektrode S parallel zu deren Seiten angeordnet. Zusätzlich ist eine weitere Hilfselektrode H horizontal ausgerichtet und oberhalb der Hauptelektrode S parallel zu dieser angeordnet.

Durch diese teilweise um die Hauptelektrode S herum vorgesehene Anordnung der Hilfselektroden H ist eine zumindest teilweise Überwachung und Erfassung der Umgebung der Hauptelektrode S ermöglicht. Hierdurch kann das Messsignal der Hauptelektrode S sicher anhand der Messsignale der Hilfselektroden H und somit anhand von Signalen aus der Umgebung der Hauptelektrode S durch Vergleich der Messsignale miteinander überprüft und auf Plausibilität ausgewertet werden.

**Figuren 2 bis 4** zeigen eine an eine Hand angepasste Form der Hauptelektrode S zur Erfassung einer Annäherung und/oder Berührung der Hand an die Hauptelektrode S. Hierzu weist die Hauptelektrode S eine kissenähnliche oder annähernd handgroße rechteckige Form auf. Dabei dient die Hauptelektrode S als Messelektrode, welche zur Auslösung der Funktion F zu betätigen oder zu berühren oder welcher sich anzunähern ist.

Die Hilfselektroden H dienen insbesondere der Überwachung der Umgebung der Hauptelektrode S. Beispielsweise werden mittels der Hilfselektroden H Fehlsignale, die beispielsweise durch eine Einwirkung E, insbesondere eine mechanische Beanspruchung oder Beaufschlagung mit Staub, Regen oder Schmutz, verursacht sind, erkannt und eine Fehlauslösung unterdrückt, indem eine Auslösung der Funktion F gesperrt oder unterdrückt wird.

In Figur 2 erfasst beispielsweise die Auswerteeinheit 6 Änderungen der Kapazität in den Elektroden 4.1, 4.2 und 4.4 aufgrund einer Einwirkung E durch Regentropfen.

Die Auswerteeinheit 6 wertet die erfassten Änderungen der Kapazitäten der Elektroden 4.1, 4.2 und 4.4 aus. Dabei können die ermittelten Werte der Elektroden 4.1, 4.2 und 4.6 miteinander verglichen werden. Zusätzlich können die ermittelten Werte der Elektroden 4.1, 4.2 und 4.6 auch mit für die jeweilige Elektrode 4.1, 4.2 bzw. 4.6 hinterlegten Referenzwerten verglichen werden. Dabei können je Elektrode 4.1 bis 4.n mehrere Referenzwerte für eine differenzierte Erkennung von Objekten 5 hinterlegt sein.

Aufgrund der in etwa gleich hohen Änderung der Kapazitäten der Elektroden 4.1, 4.2 und 4.6 ermittelt die Auswerteeinheit 6, dass lediglich eine Einwirkung E in Form von Regentropfen an der kapazitiven Sensoranordnung 4 anliegt und dass keine funktionsrelevante Annäherung eines Objekts 5, wie einer Hand vorliegt, oder eine Berührung durch ein Objekt 5 vorliegt. Daraus resultierend erzeugt die Auswerteeinheit 6 kein Steuersignal SI.

In Figur 3 detektieren die Elektroden 4.1 und 4.2 eine Einwirkung E. Mittels der Auswerteeinheit 6 wird erkannt, dass der Referenzwert für die Auslösung des Steuersignals SI durch die Kapazitätsänderung an der Elektrode 4.1, der Hauptelektrode S, nicht erreicht wird. Aus diesem Grunde unterbleibt die Erzeugung des Steuersignals SI.

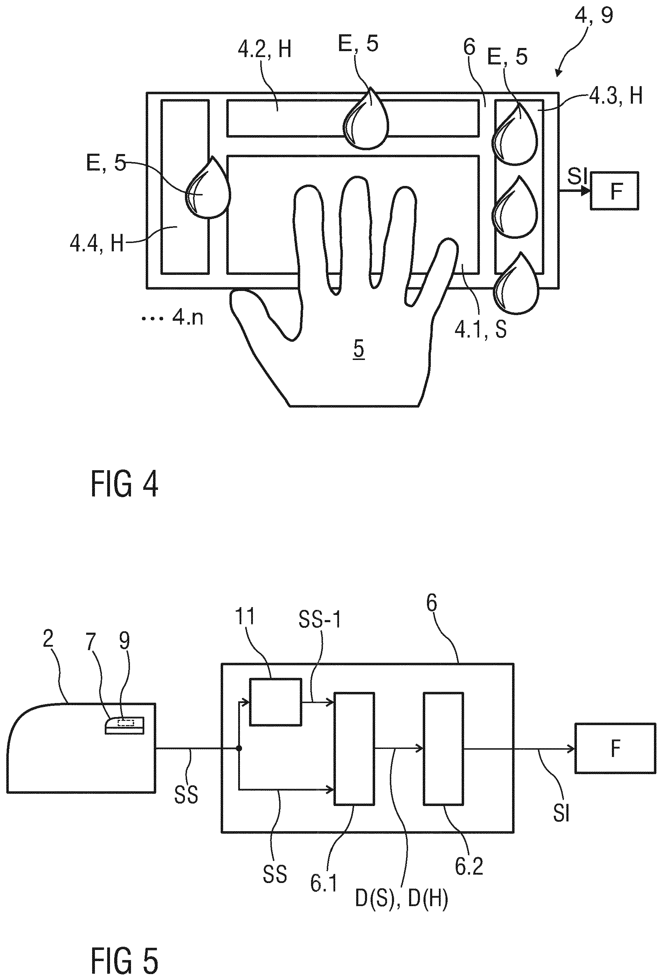

In Figur 4 ändert sich die Kapazität der Hauptelektrode S - der Elektrode 4.1 - aufgrund einer Hand als annäherndes Objekt 5 über den vorgegebenen Referenzwert hinaus und damit stärker als die Änderungen der Kapazitäten an den Hilfselektroden H - den Elektroden 4.2 bis 4.4. Somit kann mittels der Auswerteeinheit 6 auch im Fall einer Einwirkung E durch Regen sicher eine Annäherung oder Berührung eines gewünschten Objektes 5 erfasst werden.

Hierzu ist die Auswerteeinheit 6 beispielsweise eingerichtet bei einer erfassten Änderung der Kapazität in der Hauptelektrode S über einen vorgegebenen Referenzwert hinaus trotz erfasster Kapazitätsänderungen an den Hilfselektroden H, ein Steuersignal SI für eine Funktion F, beispielsweise eine Verriegelungs- oder Entriegelungsfunktion, zu erzeugen.

Unterschreitet hingegen die an der Hauptelektrode S erfasste Kapazitätsänderung einen vorgegebenen Referenzwert, so wird kein Steuersignal SI erzeugt oder die Auslösung dieses gesperrt.

Darüber hinaus kann die Auswerteeinheit 6 eingerichtet sein, einen zeitlichen Versatz und/oder eine Reihenfolge der Änderungen der Kapazitäten der Hauptelektrode S und/oder Hilfselektroden H zu ermitteln und auszuwerten. Durch eine solche spezifische Auswertung der erfassten Änderungen der Kapazitäten können Freigabebedingungen für die Funktion F zusätzlich definiert werden. Auch kann dadurch auf vorliegende Bedingungen in der Umgebung der Hauptelektrode S oder an der Hauptelektrode S selbst geschlossen werden, wie beispielsweise auf eine starke Verschmutzung des Sensors, wobei die Auswerteeinheit 6 ein entsprechendes Wartungssignal oder Reinigungssignal auslösen kann.

**Figur** 5 zeigt schematisch in vergrößerter Darstellung eine Kopplung der kapazitiven Sensoranordnung 4 mit einer Auswerteeinheit 6 und einer Schalteinheit 10.

Die Auswerteeinheit 6 ist eingerichtet, alle Elektroden 4.1 bis 4.n derart gemeinsam zu überwachen, dass Änderungen der Kapazitäten der mehreren Hilfselektroden H und Änderungen der Kapazität der Hauptelektrode S erfasst und miteinander verglichen und/oder mit vorgegebenen Referenzwerten verglichen werden.

Dazu werden der Auswerteeinheit 6 von den Elektroden 4.1 bis 4.n aktuelle Mess- oder Sensorsignale SS zugeführt und optional als vorangegangene Mess- oder Sensorsignale SS-1 gespeichert. Beispielsweise umfasst dazu die Auswerteeinheit 6 eine Speichereinheit 11. Anhand der erfassten aktuellen Mess- oder Sensorsignale SS und der vorangegangenen Mess- oder Sensorsignale SS-1 ermittelt die Auswerteeinheit 6 mittels eines Analysemoduls 6.1 Änderungen D(S) der Kapazität der Hauptelektrode S und Änderungen D(H) der Kapazitäten der mehreren Hilfselektroden H.

Darüber hinaus kann die Auswerteeinheit 6 eingerichtet sein, die erfassten Änderungen D(S) der Kapazität der Hauptelektrode S anhand der erfassten Änderungen D(H) der Kapazitäten der mehreren Hilfselektroden H auf Plausibilität dahingehend zu prüfen, ob eine Berührung der Hauptelektrode S und/oder eine Annäherung an die Hauptelektrode S erfolgt ist oder nicht. Hierzu weist die Auswerteeinheit 6 beispielsweise ein Plausibilitätsmodul 6.2 auf.

Beispielsweise ist die Auswerteeinheit 6, insbesondere deren Plausibilitätsmodul 6.2 eingerichtet, einen ermittelten zeitlichen Versatz und/oder eine ermittelte Reihenfolge der Änderungen D(S) der Kapazitäten der Hauptelektrode S und/oder der Änderungen D(H) der Kapazitäten der Hilfselektroden H auf Plausibilität dahingehend zu prüfen, ob eine Berührung der Hauptelektrode S oder eine Annäherung an die Hauptelektrode S erfolgt ist oder nicht.

Dabei ist die Auswerteinheit 6 weiter eingerichtet, bei ermittelter fehlender Plausibilität eine Auslösung einer Funktion F, insbesondere einer Schaltfunktion, zu sperren oder bei ermittelter gegebener Plausibilität eine Auslösung der Funktion F, insbesondere einer Schaltfunktion, freizugeben. Hierzu ist die Auswerteeinheit 6 ausgangsseitig mit der Schalteinheit 10 verbunden, der von der Auswerteeinheit 6 ein Steuersignal SI zum Auslösen oder Sperren der Funktion F zugeführt wird.

### BEZUGSZEICHENLISTE

- 1: Fahrzeug
- 2: Tür
- 3: Heckklappe
- 4: Kapazitive Sensoranordnung
- 4.1 bis 4.n: Elektrode
- 5: Objekt
- 6: Auswerteeinheit
- 6.1: Analysemodul
- 6.2: Plausibilitätsmodul
- 7: Fahrzeugaußengriff
- 7.1: Griffblende
- 8: Heckklappengriff
- 9: Berührungssensor
- 10: Schalteinheit
- 11: Speichereinheit

- D(S): Änderungen der Kapazitäten der Hauptelektrode
- D(H): Änderungen der Kapazitäten der Hilfselektroden
- E: Einwirkung
- F: Funktion
- S: Hauptelektrode
- SS: aktuelles Mess- oder Sensorsignal
- SS-1: vorangegangenes Mess- oder Sensorsignal
- SI: Steuersignal
- H: Hilfselektrode

## Patentansprüche

1. Kapazitive Sensoranordnung (4) für ein Fahrzeug (1) zum Erfassen mindestens eines sich annähernden Objektes (5), wobei die Sensoranordnung (4) als ein Berührungssensor (9) ausgebildet ist und eine Mehrzahl von Elektroden (4.1 bis 4.n) umfasst, die jeweils als Flächenelektrode ausgebildet sind und zueinander ausgerichtet und voneinander beabstandet angeordnet sind, wobei
- jede Elektrode (4.1 bis 4.n) eine vorgegebene Kapazität aufweist und mit einer Auswerteeinheit (6) verbunden ist, welche Änderungen (D(S), D(H)) in der Kapazität der jeweiligen Elektrode (4.1 bis 4.n) erfasst,
- eine der Elektroden (4.1) eine Hauptelektrode (S) ist, welche zur Auslösung einer Funktion (F) des Fahrzeugs (1) zu betätigen oder zu berühren ist, und
- die anderen Elektroden (4.2 bis 4.n) Hilfselektroden (H) sind, die eine Umgebung der Hauptelektrode (S) überwachen, wobei
- die Auswerteeinheit (6) eingerichtet ist, alle Elektroden (4.1 bis 4.n) gemeinsam zu überwachen derart, dass Änderungen (D(H)) der Kapazitäten der mehreren Hilfselektroden (H) und Änderungen (D(S)) der Kapazität der Hauptelektrode (S) erfasst und miteinander verglichen werden, und
- die Auswerteeinheit (6) eingerichtet ist, die erfassten Änderungen (D(S)) der Kapazität der Hauptelektrode (S) anhand der erfassten Änderungen (D(H)) der Kapazitäten der mehreren Hilfselektroden (H) auf Plausibilität zu prüfen, ob eine Berührung der Hauptelektrode (S) oder eine Annäherung an die Hauptelektrode (S) erfolgt ist oder nicht, wobei die Auswerteeinheit (6) eingerichtet ist, einen zeitlichen Versatz und/oder eine Reihenfolge der Änderungen (D(S), D(H)) der Kapazitäten der Haupt- und Hilfselektroden (S, H) zu ermitteln und auszuwerten.

2. Kapazitive Sensoranordnung (4) nach Anspruch 1, wobei die Auswerteinheit (6) eingerichtet ist, bei fehlender Plausibilität eine Auslösung einer Funktion (F) zu sperren oder bei gegebener Plausibilität eine Auslösung der Funktion (F) freizugeben.

3. Kapazitive Sensoranordnung (4) nach Anspruch 1 oder 2, wobei die Auswerteeinheit (6) eingerichtet ist, in Abhängigkeit von den ermittelten Änderungen (D(S)) der Kapazität der Hauptelektrode (S) ein Steuersignal (SI) zu erzeugen oder in Abhängigkeit von den ermittelten Änderungen (D(S), D(H)) der Kapazitäten der Hauptelektrode (S) und der Hilfselektroden (H) eine solche Erzeugung eines Steuersignals (SI) zu sperren.

4. Kapazitive Sensoranordnung (4) nach einem der vorhergehenden Ansprüche, wobei die Elektroden(4.1 bis 4.n) als Streifenelektroden oder Rechteckelektroden ausgebildet sind.

5. Kapazitive Sensoranordnung (4) nach einem der vorhergehenden Ansprüche, wobei die Hauptelektrode (S) größere Abmessungen aufweist als die Hilfselektroden (H).

6. Kapazitive Sensoranordnung (4) nach einem der vorhergehenden Ansprüche, wobei die Hilfselektroden (H) als Streifenelektroden ausgebildet sind und jeweils benachbart zur Hauptelektrode (S) angeordnet sind.

7. Kapazitive Sensoranordnung (4) nach einem der vorhergehenden Ansprüche, wobei die jeweilige Hilfselektrode (H) zumindest eine Länge aufweist, die einer Seitenlänge der Hauptelektrode (S) entspricht.

8. Kapazitive Sensoranordnung (4) nach einem der vorhergehenden Ansprüche, wobei bei einer erfassten Änderung (D(S)) der Kapazität in der Hauptelektrode (S) über einen vorgegebenen Referenzwert hinaus die Auswerteeinheit (6) ein Steuersignal (SI) ausgibt.

9. Kapazitive Sensoranordnung (4) nach einem der vorgehenden Ansprüche, wobei bei einer erfassten Änderung (D(H)) der Kapazität nur in den zu der Hauptelektrode (S) benachbarten Hilfselektroden (H) die Auswerteeinheit (6) die Auslösung eines Steuersignals (SI) sperrt.

10. Kapazitive Sensoranordnung (4) nach einem der vorhergehenden Ansprüche, wobei zumindest zwei der Hilfselektroden (H) vertikal ausgerichtet sind und seitlich der Hauptelektrode (S) parallel zu deren Seiten angeordnet sind.

11. Kapazitive Sensoranordnung (4) nach einem der vorhergehenden Ansprüche, wobei zumindest eine der Hilfselektroden (H) horizontal ausgerichtet ist und oberhalb der Hauptelektrode (S) parallel zu dieser angeordnet ist.

12. Kapazitive Sensoranordnung (4) nach Anspruch 1, wobei die Auswerteeinheit (6) eingerichtet ist, den ermittelten zeitlichen Versatz und/oder die ermittelte Reihenfolge der Änderungen (D(S)) der Kapazitäten von Hauptelektrode (S) und der Änderungen (D(H)) der Kapazitäten von Hilfselektroden (H) auf Plausibilität zu prüfen, ob eine Berührung der Hauptelektrode (S) oder eine Annäherung an die Hauptelektrode (S) erfolgt ist oder nicht.

13. Fahrzeugaußenoberfläche mit einer kapazitiven Sensoranordnung (4) nach einem der vorhergehenden Ansprüche 1 bis 12.

14. Fahrzeugaußengriff (7) mit einer kapazitiven Sensoranordnung (4) nach einem der Ansprüche 1 bis 12.

## Claims

1. Capacitive sensor arrangement (4) for a vehicle (1) for sensing at least one approaching object (5), wherein the sensor arrangement (4) is configured as a contact sensor (9) and comprises a plurality of electrodes (4.1 to 4.n) that are each configured as flat electrodes and aligned with one another and arranged spaced apart from one another, wherein
- each electrode (4.1 to 4.n) has a prescribed capacitance and is connected to an evaluation unit (6), which senses changes (D(S), D(H)) in the capacitance of the respective electrode (4.1 to 4.n),
- one of the electrodes (4.1) is a main electrode (S) that needs to be actuated or contacted to activate a function (F) of the vehicle (1), and
- the other electrodes (4.2 to 4.n) are auxiliary electrodes (H) that monitor an environment of the main electrode (S), wherein
- the evaluation unit (6) is set up to monitor all of the electrodes (4.1 to 4.n) together, such that changes (D(H)) in the capacitances of the plurality of auxiliary electrodes (H) and changes (D(S)) in the capacitance of the main electrode (S) are sensed and compared with one another, and
- the evaluation unit (6) is set up to check the sensed changes (D(S)) in the capacitance of the main electrode (S) on the basis of the sensed changes (D(H)) in the capacitances of the plurality of auxiliary electrodes (H) in terms of plausibility as to whether or not contacting of the main electrode (S) or an approach towards the main electrode (S) has taken place, wherein the evaluation unit (6) is set up to determine and evaluate a temporal offset and/or a sequence of the changes (D(S), D(H)) in the capacitances of the main and auxiliary electrodes (S, H) .

2. Capacitive sensor arrangement (4) according to Claim 1, wherein the evaluation unit (6) is set up, in the event of a lack of plausibility, to block activation of a function (F) or, in the event of a presence of plausibility, to release activation of the function (F).

3. Capacitive sensor arrangement (4) according to Claim 1 or 2, wherein the evaluation unit (6) is set up to generate a control signal (SI) depending on the determined changes (D(S)) in the capacitance of the main electrode (S) or to block such generation of a control signal (SI) depending on the determined changes (D(S), D(H)) in the capacitances of the main electrode (S) and the auxiliary electrodes (H).

4. Capacitive sensor arrangement (4) according to one of the preceding claims, wherein the electrodes (4.1 to 4.n) are configured as strip electrodes and/or rectangular electrodes.

5. Capacitive sensor arrangement (4) according to one of the preceding claims, wherein the main electrode (S) has larger dimensions than the auxiliary electrodes (H).

6. Capacitive sensor arrangement (4) according to one of the preceding claims, wherein the auxiliary electrodes (H) are configured as strip electrodes and are arranged in each case next to the main electrode (S).

7. Capacitive sensor arrangement (4) according to one of the preceding claims, wherein the respective auxiliary electrode (H) has at least a length that corresponds to a lateral length of the main electrode (S).

8. Capacitive sensor arrangement (4) according to one of the preceding claims, wherein, in the event of a sensed change (D(S)) in the capacitance in the main electrode (S) beyond a prescribed reference value, the evaluation unit (6) emits a control signal (SI).

9. Capacitive sensor arrangement (4) according to one of the preceding claims, wherein, in the event of a sensed change (D(H)) in the capacitance only in the auxiliary electrodes (H) next to the main electrode (S), the evaluation unit (6) blocks the activation of a control signal (SI).

10. Capacitive sensor arrangement (4) according to one of the preceding claims, wherein at least two of the auxiliary electrodes (H) are aligned vertically and arranged laterally with respect to the main electrode (S), parallel to the sides thereof.

11. Capacitive sensor arrangement (4) according to one of the preceding claims, wherein at least one of the auxiliary electrodes (H) is aligned horizontally and arranged above the main electrode (S), parallel thereto.

12. Capacitive sensor arrangement (4) according to Claim 1, wherein the evaluation unit (6) is set up to check the determined temporal offset and/or the determined sequence of the changes (D(S)) in the capacitances of the main electrode (S) and of the changes (D(H)) in the capacitances of auxiliary electrodes (H) in terms of plausibility as to whether or not contacting of the main electrode (S) or an approach towards the main electrode (S) has taken place.

13. Vehicle outer surface having a capacitive sensor arrangement (4) according to one of preceding Claims 1 to 12.

14. Vehicle outer handle (7) having a capacitive sensor arrangement (4) according to one of Claims 1 to 12.

## Revendications

1. Ensemble capteur capacitif (4) pour un véhicule (1) destiné à détecter au moins un objet (5) en approche, l'ensemble capteur (4) étant formé comme un capteur tactile (9) et comprenant une multitude d'électrodes (4.1 à 4.n) qui sont formées chacune comme une électrode de surface et sont alignées les unes par rapport aux autres et sont espacées les unes des autres,
- chaque électrode (4.1 à 4.n) présentant une capacité prédéfinie et étant reliée à une unité d'évaluation (6), qui détecte des variations (D(S), D(H)) de la capacité de l'électrode (4.1 à 4.n) respective,
- une des électrodes (4.1) étant une électrode principale (S) qui doit être actionnée ou mise en contact pour déclencher une fonction (F) du véhicule (1), et
- les autres électrodes (4.2 à 4.n) étant des électrodes auxiliaires (H), qui surveillent un environnement de l'électrode principale (S),
- l'unité d'évaluation (6) étant mise au point pour surveiller ensemble toutes les électrodes (4.1 à 4.n) de telle manière que des variations (D(H)) des capacités des plusieurs électrodes auxiliaires (H) et des variations (D(S)) de la capacité de l'électrode principale (S) sont détectées et comparées les unes aux autres, et
- l'unité d'évaluation (6) étant mise au point pour vérifier la plausibilité des variations (D(S)) détectées de la capacité de l'électrode principale (S) à l'aide des variations (D(H)) détectées des capacités des plusieurs électrodes auxiliaires (H) pour déterminer si un contact avec l'électrode principale (S) ou un rapprochement de l'électrode principale (S) ont eu lieu, l'unité d'évaluation (6) étant mise au point pour déterminer et évaluer un décalage temporel et/ou un ordre des variations (D(S), D(H)) des capacités de l'électrode principale et des électrodes auxiliaires (S, H).

2. Ensemble capteur capacitif (4) selon la revendication 1, l'unité d'évaluation (6) étant mise au point pour bloquer un déclenchement d'une fonction (F) en cas d'absence de plausibilité ou pour permettre un déclenchement de la fonction (F) en cas de plausibilité donnée.

3. Ensemble capteur capacitif (4) selon la revendication 1 ou 2, l'unité d'évaluation (6) étant mise au point pour générer un signal de commande (SI) en fonction des variations (D(S)) déterminées de la capacité de l'électrode principale (S) ou pour bloquer une telle génération d'un signal de commande (SI) en fonction des variations (D(S), D(H)) déterminées des capacités de l'électrode principale (S) et des électrodes auxiliaires (H).

4. Ensemble capteur capacitif (4) selon l'une des revendications précédentes, les électrodes (4.1 à 4.n) étant formées comme des électrodes en bande ou des électrodes rectangulaires.

5. Ensemble capteur capacitif (4) selon l'une des revendications précédentes, l'électrode principale (S) présentant des dimensions plus grandes que les électrodes auxiliaires (H).

6. Ensemble capteur capacitif (4) selon l'une des revendications précédentes, les électrodes auxiliaires (H) étant formées comme des électrodes en bande et étant disposées chacune de manière adjacente à l'électrode principale (S).

7. Ensemble capteur capacitif (4) selon l'une des revendications précédentes, l'électrode auxiliaire (H) respective présentant au moins une longueur qui correspond à une longueur latérale de l'électrode principale (S).

8. Ensemble capteur capacitif (4) selon l'une des revendications précédentes, l'unité d'évaluation (6) émettant un signal de commande (SI) en présence d'une variation (D(S)) détectée de la capacité dans l'électrode principale (S) au-delà d'une valeur de référence prédéfinie.

9. Ensemble capteur capacitif (4) selon l'une des revendications précédentes, l'unité d'évaluation (6) bloquant le déclenchement d'un signal de commande (SI) en présence d'une variation (D(H)) détectée de la capacité uniquement dans les électrodes auxiliaires (H) adjacentes à l'électrode principale (S).

10. Ensemble capteur capacitif (4) selon l'une des revendications précédentes, au moins deux des électrodes auxiliaires (H) étant orientées verticalement et étant disposées à côté de l'électrode principale (S) parallèlement aux côtés de celle-ci.

11. Ensemble capteur capacitif (4) selon l'une des revendications précédentes, au moins une des électrodes auxiliaires (H) étant orientée horizontalement et étant disposée au-dessus de l'électrode principale (S) parallèlement à celle-ci.

12. Ensemble capteur capacitif (4) selon la revendication 1, l'unité d'évaluation (6) étant mise au point pour vérifier la plausibilité du décalage temporel déterminé et/ou de l'ordre déterminé des variations (D(S)) des capacités de l'électrode principale (S) et des variations (D(H)) des capacités des électrodes auxiliaires (H) pour déterminer si un contact avec l'électrode principale (S) ou un rapprochement de l'électrode principale (S) ont eu lieu ou non.

13. Surface extérieure de véhicule avec un ensemble capteur capacitif (4) selon l'une des revendications précédentes 1 à 12.

14. Poignée extérieure (7) de véhicule avec un ensemble capteur capacitif (4) selon l'une des revendications 1 à 12.
